# EUROPEAN PATENT APPLICATION

(11) **EP 4 852 656 A1**
(43) Date of publication of application: **09.12.2026**
(21) Application number: 25220018.3
(22) Date of filing: 02.12.2025
(51) Int. Cl.: H10D 89/60, H02H 9/04

(54) **BIPOLAR DEVICES IN SUBFIN FOR ELECTROSTATIC DISCHARGE PROTECTION**

(30) Priority: 04.06.2025 US 202519227876
(71) Applicant: INTEL Corporation, Santa Clara, CA 95054 (US)
(72) Inventor: VORA, Sandeep, Austin, 78748 (US); ORR, Benjamin, Beaverton, 97008 (US); AHSAN, Akm, Portland, 97229 (US); THOMSON, Nicholas, Beaverton, 97007 (US); PAUL, Milova, Hillsboro, 97124 (US)
(74) Representative: Viering, Jentschura & Partner mbB Patent- und Rechtsanwälte

(57) **Abstract**

A bipolar device provides ESD protection in gate-all-around and other substrate-less technologies by forming bipolar snapback devices in a retained subfin region. The device layer may have multiple regions (e.g., a transistor region and a bipolar device region), where the subfin is retained in the bipolar device region. Specific implant masks may be used to create the p-n junctions within the subfin, while epitaxial deposition, aligned with standard CMOS logic processing, forms base, collector, and emitter regions over the subfin. The subfin may be removed in other regions, e.g., the transistor region, enabling backside contacts.

## Description

### Background

Electrostatic discharge (ESD) events can be damaging for electronic devices. Transistors and other semiconductor-based devices typically have a voltage tolerance; if the voltage tolerance for a particular device is exceeded, the device may be damaged or degraded. ESD events can create voltage spikes or excess charges that can damage these electronic devices. Thus, when designing integrated circuit (IC) devices or packages, it is useful to have a way to protect against ESD events.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a circuit diagram of a bipolar device for ESD protection, according to some embodiments of the present disclosure.
FIG. 2 illustrates an example I-V curve for the bipolar devices disclosed herein, according to some embodiments of the present disclosure.
FIG. 3 is a cross-section of a first bipolar device formed in a subfin region, according to some embodiments of the present disclosure.
FIG. 4 is a cross-section of a second bipolar device formed in a subfin region with greater base-to-emitter and emitter-to-collector spacing, according to some embodiments of the present disclosure.
FIG. 5 is a cross-section of a third bipolar device formed in a subfin region with a portion of the subfin having natural doping levels, according to some embodiments of the present disclosure.
FIG. 6 is a cross-section of a fourth bipolar device formed in a subfin region with the base and emitter swapped, according to some embodiments of the present disclosure.
FIG. 7 is a cross-section of a device including a bipolar device region with a retained subfin and a transistor region with the subfin removed, according to some embodiments of the present disclosure.
FIGS. 8A and 8B are top views of a wafer and dies that include one or more bipolar devices in accordance with any of the embodiments disclosed herein.
FIG. 9 is a cross-sectional side view of an IC device that may include one or bipolar devices in accordance with any of the embodiments disclosed herein.
FIG. 10 is a cross-sectional side view of an IC device assembly that may include one or more bipolar devices in accordance with any of the embodiments disclosed herein.
FIG. 11 is a block diagram of an example computing device that may include one or more bipolar devices in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

ESD events pose a significant risk to electronic devices, particularly ICs, as they can cause voltage spikes that exceed the tolerance levels of transistors and other semiconductor components. Traditional ESD protection methods, such as dual diode configurations, are unsuitable for failsafe and fault-tolerant input/output (IO) designs because they activate in a manner incompatible with these applications. Bipolar snapback devices, such as bipolar junction transistors (BJTs), may be used for these scenarios due to their shallow snapback characteristics and low on-resistance. In ICs with FinFET and planar transistor arrangements, bipolar snapback devices may be formed in the substrate. For example, base, emitter, and collector regions formed in and/or over the substrate and are isolated by shallow-trench isolation (STI); the current path between the regions travels under the STI. However, in substrate-less technologies, such as gate-all-around (GAA) nanowire architectures, the conventional current path through the substrate is no longer available, creating challenges in implementing effective ESD protection.

The bipolar devices described herein enable ESD protection in GAA and other substrate-less technologies by forming bipolar snapback devices in a retained subfin region. The device layer may have multiple regions (e.g., a transistor region and a bipolar device region), where the subfin is retained in the bipolar device region, ensuring a current path through the subfin for the bipolar device. The subfin may be removed in other regions, e.g., the transistor region, enabling backside contacts. Specific implant masks may be used to create the p-n junctions within the subfin, while other process steps (e.g., epitaxial deposition) are aligned with standard CMOS logic processing, minimizing complexity and cost.

An IC device includes various circuit elements, such as transistors and, in this case, bipolar devices, that are coupled together by metal interconnects. The circuit elements and metal interconnects may be formed in different layers. In particular, one or more layers of an IC device in which transistors, bipolar devices, and/or other IC components are implemented may be referred to as a "transistor layer" or "device layer". Layers with conductive interconnects for providing electrical connectivity (e.g., in terms of signals and power) to the transistors and/or other devices of the transistor layer of the IC device may be referred to as a "metal layer," "metallization layer," or "interconnect layer". For example, the device layer may be a front-end-of-line (FEOL) layer, while the metal layers may be back-end-of-line (BEOL) layers formed over the FEOL layer. A set of metallization layers are referred to as a metallization stack. In some embodiments disclosed herein, a first metallization stack is formed over a front side of the device layer, and a second metallization stack is formed over the back side of the IC device, i.e., on an opposite side of the device layer from the first metallization stack. The first metallization stack may be coupled to front-side contacts of the bipolar devices and, in some cases, to front-side contacts of the transistors. The second metallization stack may be coupled to back-side contacts of the transistors.

In general, forming device contacts on the back side of the device can provide certain advantages. For example, including both front and back side contacts enables routing on both sides of the device, which can offer different options for forming connections between transistors. Furthermore, including contacts and routing on both sides of the device can also help increase density of transistors. To fabricate backside contacts, at least some portions of the devices and routing are typically formed over a front side of the wafer, followed by a metallization stack, as described above. The assembly is then flipped, and the wafer is thinned, e.g., by a grinding process, to reveal the back side of the devices. Then, the backside contacts are formed on the back sides of the transistor, followed by one or more back-side metal layers. Removing most or all of the thickness of the wafer can result in a relatively thin IC package. As noted above, in the bipolar devices disclosed herein, the subfin portion of the wafer, nearest to the transistors and other devices, is retained in the bipolar device region. The subfin portion may be removed in the transistor region, enabling formation of backside contacts.

As noted above, the bipolar devices described herein are formed within a device plane, with at least a portion of the bipolar devices being coplanar with transistors (e.g., epitaxial regions for the base, collector, and emitter may be in the same plane as the transistors). The bipolar device further includes a subfin region having two sub-regions of different semiconductor types, forming a p-n junction.

Embodiments of the transistors described herein include nanoribbon or nanowire-based semiconductors regions forming the bulk semiconductor material. In general, in a nanowire-based transistor or nanoribbon-based transistor (referred to generally as a nanoribbon transistor), a gate stack that may include a stack of one or more gate electrode metals and, optionally, a stack of one or more gate dielectrics may be provided around one or more elongated semiconductor structures called "nanoribbons", forming a gate on all sides of the nanoribbon or nanoribbons. A portion of a nanoribbon around which the gate stack wraps around is referred to as a "channel" or a "channel portion." A semiconductor material of which the channel portion of the nanoribbon is formed is commonly referred to as a "channel material." A source region and a drain region are provided on the opposite ends of the nanoribbon, on either side of the gate stack, forming, respectively, a source and a drain of such a transistor.

The bipolar devices described herein may be implemented in combination with one or more components associated with an IC. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details and/or that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value, unless specified otherwise. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g., logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

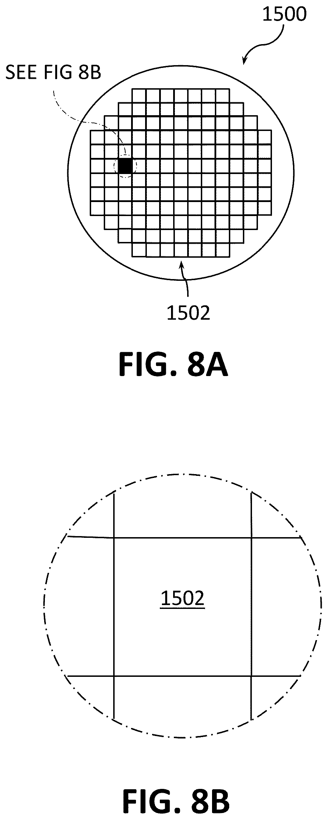

For convenience, if a collection of drawings designated with different letters are present, e.g., FIGS. 8A-8B, such a collection may be referred to herein without the letters, e.g., as "FIG. 8."

### Example Circuit Diagram of Bipolar Device for ESD Protection

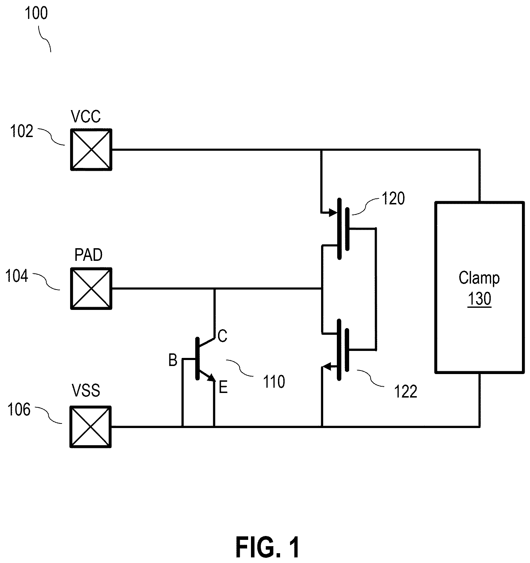

FIG. 1 is a circuit diagram of an ESD protection circuit 100 including a bipolar device, according to some embodiments of the present disclosure. The ESD protection circuit 100 (also referred to as a circuit 100) may be an element of an IC that includes other devices, e.g., transistor devices, memory devices, etc. The circuit 100 is coupled to other elements in the IC to provide protection for ESD events. In particular, the circuit 100 may be coupled to an I/O pad or pin to protect the IC from ESD events in an external device connected to the IC. The circuit 100 may provide failsafe and fault tolerant I/O protection, meaning that the circuit 100 may protect the IC when the power (VCC) is turned off, and withstand and respond properly to ESD events.

The voltage source 102 (VCC) is the power supply for the circuit 100. With respect to electrostatic discharge (ESD) protection, the voltage source 102 may contribute to maintaining the operational voltage range of the IC while allowing the bipolar device 110 to activate under ESD conditions. The connection between the voltage source 102 and other components, such as the transistors 120 and 122, may support the circuit 100 in handling transient voltage spikes. The voltage source 102 may be implemented using various technologies, such as a regulated power supply or an external battery, depending on the application requirements.

Electrical signals, in the form of input/output (I/O or IO) interactions, may be provided to the pad 104, which serves as an I/O interface for the IC. In various embodiments, the pad 104 may be directly connected to the bipolar device 110 (e.g., the collector region of the bipolar device 110) as well as the transistors 120 and 122. This connection may facilitate the pad 104 in interacting with external devices while concurrently protecting the IC from ESD events. The pad 104 may be implemented using conductive materials, such as aluminum or copper, and may be designed to accommodate various signal types, including analog, digital, or power signals.

The ground connection 106 (VSS) establishes a reference voltage level for the circuit 100. In various embodiments, the ground connection 106 may be coupled to the emitter (E) region of the bipolar device 110 and other circuit elements, thereby supporting proper operation and stability of the circuit 100. The ground connection 106 may serve as a discharge path for excess charges generated during an ESD event. This connection may help to prevent damage to the IC by safely dissipating transient energy. In some embodiments, the ground connection 106 may be implemented using various techniques, such as a dedicated ground plane or a conductive trace, in accordance with the design requirements of the IC.

The ESD protection circuit 100 includes a bipolar device 110, comprising the base (B), emitter (E), and collector (C) regions. As described herein, the bipolar device 110 may be formed in the subfin region of the IC, utilizing a retained subfin layer to create a current path through the bipolar device 110. For example, the base (B) region may be formed with p-type epitaxial growth over a p-doped subfin region, while the emitter (E) region may be formed with n-type epitaxial growth over the same p-type subfin region, and the collector (C) region may be formed with n-type epitaxial growth in an adjacent n-doped subfin region. Accordingly, this configuration may create a p-n junction between the base (B) and emitter (E) regions as well as between the emitter (E) and collector (C) regions, thereby enabling the bipolar device 110 to activate under ESD conditions. The bipolar device 110 may provide shallow snapback characteristics and low on-resistance, rendering the device suitable for failsafe and fault-tolerant IO designs.

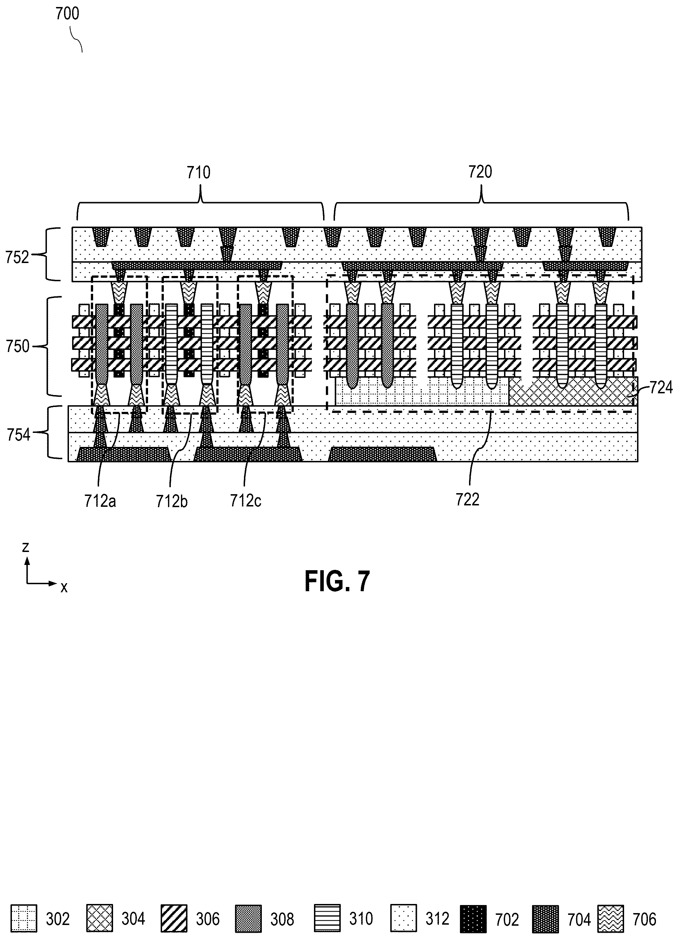

The transistors 120 and 122 are active components within the circuit 100, interacting with the bipolar device 110 to provide additional functionality and control. The transistor 120 may be connected to the voltage source 102 (VCC) and the clamp 130, thereby regulating the flow of current through the circuit 100. The transistor 122 may be connected to the ground connection 106 and the clamp 130, providing a discharge path for excess charges during ESD events. The transistor 120 and the transistor 122 may be implemented using GAA nanowire technology, e.g., as illustrated in FIG. 7. The transistors 120 and 122 may serve to control the activation of the bipolar device 110 during ESD events while ensuring proper operation of the IC under typical operating conditions.

The clamp 130 may serve as a passive component within the circuit 100. The clamp 130 may limit the voltage levels during ESD events and protect the IC from damage. The clamp 130 may be connected to both transistors 120 and 122 as well as the bipolar device 110, thereby ensuring that the circuit 100 manages voltage spikes effectively. For example, the clamp 130 may be implemented using various technologies, such as silicon-controlled rectifiers (SCRs) or resistive-capacitive (RC) networks, in accordance with the application requirements.

The bipolar device 110 illustrated in FIG. 1 is depicted as an NPN BJT, in which the emitter (E) and collector (C) regions are doped with n-type material, and the base (B) region is doped with p-type material. In alternative embodiments, the bipolar device 110 can be implemented as a PNP BJT, wherein the emitter and collector regions are doped with p-type material, and the base region is doped with n-type material. Such a PNP configuration can similarly form the p-n junction to enable snapback behavior, such that the circuit 100 can be adapted to conform with existing fabrication processes of the IC.

### I-V Curve of Bipolar Device

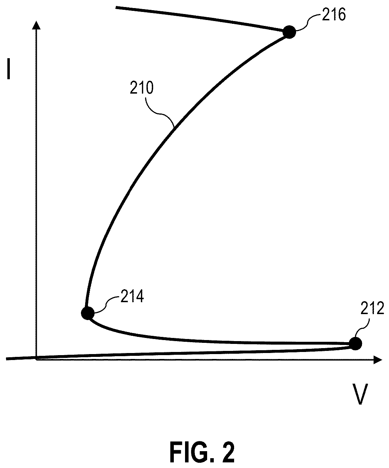

FIG. 2 illustrates an example I-V curve 210 for the bipolar devices disclosed herein, according to some embodiments of the present disclosure. FIG. 2 depicts voltage and current characteristics under various operating conditions.

The I-V curve 210 includes three notable voltage points: V_{trigger} 212, V_{hold} 214, and V_{fail} 216. Below V_{trigger} 212, the bipolar device 110 is in an "off" state with a high impedance. V_{trigger} 212 represents the voltage at which the bipolar device 110 activates, thereby initiating the snapback mechanism. This snapback activation occurs when the voltage across the device exceeds the threshold V_{trigger} 212, causing the bipolar device 110 to enter a conductive state and commence dissipation of excess charge. In the snapback region, after V_{trigger} 212 is reached, the voltage drops to V_{hold} 214 while the current increases. This region is also referred to as a negative differential resistance region. V_{trigger} 212 may be, for example, between 0.2 and 2 V, between 0.2 and 1 V, between 0.5 and 1.5 V, between 1 V and 2V, or within some other range.

Following activation, the bipolar device 110 may remain in a conductive state at or above V_{hold} 214, which is lower than V_{trigger} 212. V_{hold} 214 represents a stable operating point during an ESD event. More specifically, the bipolar device 110 may be in an "on" state between V_{hold} 214 and V_{fail} 216. V_{hold} 214 is a minimum voltage for the bipolar device 110 to conduct; if the voltage drops below V_{hold} 214, the bipolar device 110 turns off and returns to the high-impedance "off" state. This ensures that the bipolar device 110 latches only under sustained high-energy conditions, e.g., an ESD event. The shallow snapback characteristic of the bipolar device 110 ensures that the transition from V_{trigger} 212 to V_{hold} 214 occurs smoothly, minimizing the risk of damage to the integrated circuit and supporting low on-resistance for effective current dissipation.

V_{fail} 216 represents the voltage level where the bipolar device 110 stops functioning effectively, either due to current or voltage levels surpassing the device's tolerance. The V_{fail} 216 point defines the upper boundary of the operational range of the bipolar device; the bipolar device 110 may be designed with a sufficiently high V_{fail} 216 to ensure that the bipolar device 110 can endure high-energy ESD events without affecting its structural integrity or the performance of the IC.

### Example Bipolar Devices in Subfin Region

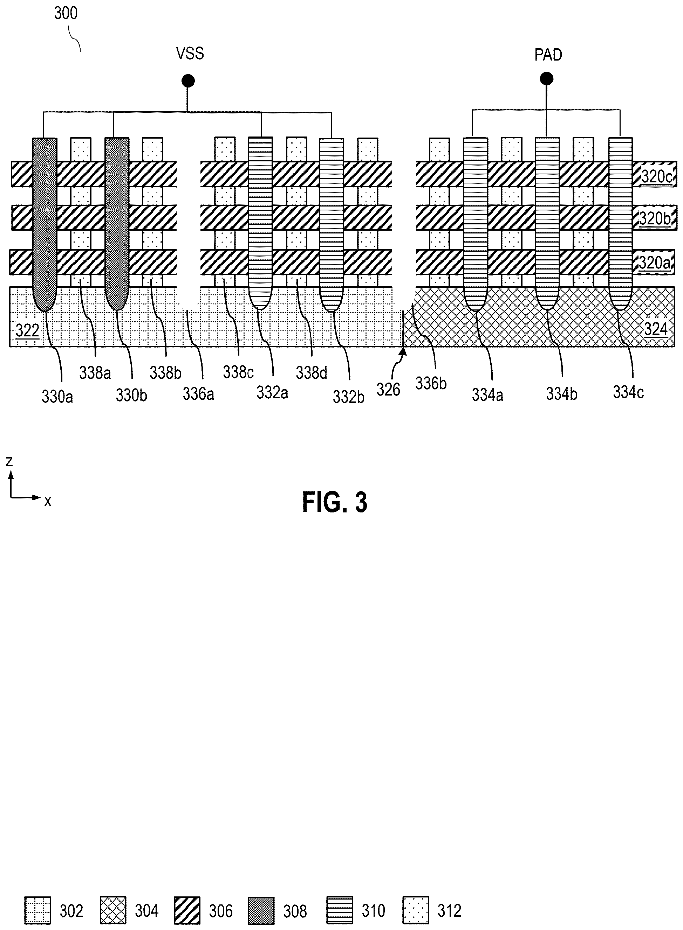

FIG. 3 is a cross-section of a first bipolar device formed in a subfin region, according to some embodiments of the present disclosure. The device 300 is an example of the bipolar device 110 of FIG. 1, and may have the I-V characteristics of FIG. 2. A number of elements referred to in the description of FIGs. 3-7 with reference numerals are illustrated in the figures with different patterns, with a legend showing the correspondence between the reference numerals and patterns provided at the bottom of the drawing pages. For example, the legend in FIG. 3 illustrates that FIG. 3 uses different patterns to show a first subfin material 302, a second subfin material 304, a semiconductor material 306, a first doped material 308, a second doped material 310, and a dielectric material 312.

Device 300 includes a stack of nanoribbons 320a, 320b, and 320c over a subfin layer, which includes the first subfin material 302 and second subfin material 304. The nanoribbons 320 are elongated semiconductor structures that may be formed as part of the standard GAA process. The nanoribbons 320a, 320b, and 320 are referred to collectively as nanoribbons 320 or individually as a nanoribbon 320. While three nanoribbons 320 are illustrated, any number of nanoribbons may be included. Each nanoribbon 320 is at a different height in the z-direction in the orientation shown in FIG. 3, i.e., a different distance from the subfin, where the nanoribbon 320c is the greatest distance from the subfin, and the nanoribbon 320a is the smallest distance from the subfin. The nanoribbons 320 are positioned above the subfin layer and extend horizontally (but not continuously, as discussed below) through the device 300. The device 300 may be formed in a same device plane with nanoribbon transistors, e.g., as illustrated in FIG. 7, for efficient fabrication and compatibility with advanced nanowire technologies.

In general, to form nanoribbons for a GAA process, alternating layers of the semiconductor material 306 and a sacrificial material are deposited over a support structure. The sacrificial material may be removed during processing, and is not shown in FIG. 3. The semiconductor material 306 and sacrificial material include different materials. In one example, the semiconductor material 306 is silicon, while the sacrificial material includes silicon and germanium. The sacrificial material may be chosen to have a similar crystal structure to the semiconductor material 306, so that monocrystalline layers of the semiconductor material 306 (or substantially monocrystalline layers, e.g., with a grain size of at least 5 nanometers, at least 20 nanometers, at least 50 nanometers, or at least 100 nanometers) and monocrystalline layers of the sacrificial material (or substantially monocrystalline layers) may be formed over each other. In different embodiments, the semiconductor material 306 and/or the sacrificial material may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

More generally, the semiconductor material 306 may be composed of semiconductor material systems including, for example, N-type or P-type materials systems. In other embodiments, the semiconductor material 306 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. The semiconductor material 306 may include one or more of cobalt oxide, copper oxide, ruthenium oxide, nickel oxide, niobium oxide, copper peroxide, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc.

In a typical GAA process, dummy gates 338 (e.g., dummy gates 338a, 338b, 338c, and 338d) are formed over the layers of semiconductor material 306. For transistor devices, dummy gates 338 are replaced with gate stacks, e.g., a gate dielectric and a gate electrode. In the bipolar device region, the dummy gates 338 may be formed around the nanoribbons 320 and remain in the device, without being replaced by gate electrodes, as shown in FIG. 3. In some other embodiments, the dummy gates may not be formed in the bipolar device region, or the dummy gates may be removed and replaced with a different dielectric material (e.g., a same dielectric that fills in the undercut regions 336). Dummy gates 338 may be formed using photolithographic patterning processes, to deposit dummy gate materials in certain areas and not in others. As illustrated in FIG. 3, a series of dummy gates 338 are formed over and around the semiconductor material 306. The dummy gates 338 are spaced apart from each other.

The dummy gates 338 are formed from a dielectric material 312. Suitable dielectric materials may include low-k or high-k dielectrics including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

As noted above, during GAA processing, the nanoribbons may be formed by depositing alternating layers of the semiconductor material 306 and the sacrificial material over a substrate. The first well 322 and second well 324 may be formed in a retained portion of the substrate that is doped to form a p-well and n-well. The substrate may silicon and/or hafnium. More generally, the substrate may be a semiconductor substrate or other support structure composed of semiconductor material systems including, for example, N-type or P-type materials systems. In one implementation, the substrate may be a crystalline substrate formed using a bulk silicon or a silicon-on-insulator (SOI) substructure. In other implementations, the substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. Although a few examples of materials from which the substrate may be formed are described here, any material that may serve as a foundation upon which the device 300 may be built falls within the spirit and scope of the present disclosure.

After forming the alternating layers of semiconductor material 306 and the sacrificial material over the substrate, the alternating layers, and at least a portion of the underlying support structure, are etched into fin shapes. The upper layers (e.g., layers of the semiconductor material 306) are further processed to form nanoribbons, while the etched portion of the substrate may have a fin shape that extends horizontally in the x-direction in the orientation shown, and also extends vertically in the z-direction. These fin-shaped regions below the nanoribbons are referred to as subfins. Adjacent subfins in the y-direction may be separated by etched regions, as is known in the art. In transistor regions of the IC device, the subfin region may be removed during later processing (e.g., to form backside contacts), but in the device 300, the subfin region is retained. The subfin region may have a height of, e.g., 20-200 nanometers or a range therein, e.g., 25-50 nanometers, 50-100 nanometers, etc.

The subfin material may have a natural dopant, e.g., n-type or p-type doping. At least one of the first well 322 and second well 324 may have an additional dopant introduced, e.g., for an n-type substrate, a p-type dopant may be added to the first well 322 to form a p-well. In some embodiments, each of the first well 322 and second well 324 are blocked in turn to add alternate dopant types to different portions of the substrate to form the first subfin material 302 and second subfin material 304. For example, the first subfin material 302 may be silicon doped with boron or another p-type dopant, and the second subfin material 304 may be silicon doped with phosphorous, arsenic, or another n-type dopant.

The first well 322 and second well 324 form a p-n junction 326. The first well 322 and second well 324 ensure a continuous current path for the device 300. The wells 322 and 324 also provide foundational support for epitaxial regions 330, 332, and 334.

The base regions 330a and 330b, emitter regions 332a and 332b, and collector regions 334a, 334b, and 334c are formed by epitaxial growth in cuts made through the nanoribbons 320a, 320b, and 320c. While FIG. 3 illustrates two base regions 330a and 330b (referred to generally as base regions 330), two emitter regions 332a and 332b (referred to generally as emitter regions 332), and three collector regions 334a, 334b, and 334c (referred to generally as collector regions 334), more or fewer of each type of region may be included. For example, a bipolar device may include three or more of the base regions 330 and/or three or more of the emitter regions 332.

The base regions 330, emitter regions 332, and collector regions 334 may be formed in a similar manner to forming source and drain regions in a nanoribbon transistor. For example, epitaxial regions 330, 332, and 334 may be formed during the same epitaxial deposition processes in which source and drain regions are formed in other areas of the IC. Prior to epitaxial deposition, regions of the nanoribbons 320 are removed by an etching process; this etching process may extend to the subfin layer, and portions of the first well 322 and well 324 may be removed and replaced with epitaxial growth, as illustrated in FIG. 3. In particular, base regions 330 are deposited over the first well 322; emitter regions 332 are also deposited over the first well 322 (in a different region of the first well 322 than the base regions 330); and collector regions 334 are deposited over the well 324. The epitaxial regions 330, 332, and 334 are directly coupled to, e.g., in direct contact with the respective well 322 or 324. In the example of FIG. 3, the epitaxial regions 330, 332, and 334 extend partially into the wells 322 and 324, e.g., into openings formed in the wells 322 and 324.

The base regions 330 are formed from a first doped material 308, which has a same dopant type as the first subfin material 302. For example, if first subfin material 302 is a p-type material, first doped material 308 is also a p-type material. The emitter regions 332 and collector regions 334 are formed from a second doped material 310, which has a same dopant type as the second subfin material 304. For example, if second subfin material 304 is an n-type material, second doped material 310 is also an n-type material. This set of dopants results in an NPN bipolar device. As noted above, alternatively, device 300 may be a PNP device; in this case, each of the dopant types are switched from the example above.

The emitter regions 332 are arranged between the base regions 330 and collector regions 334. The emitter regions 332 are separated from the base regions 330 by an undercut region 336a, and the emitter regions 332 are separated from the collector regions 334 by another undercut region 336b. Each of the undercut regions 336 is a portion of the nanoribbons 320 and subfin layer that are etched out (e.g., during the process for forming the sources, drains, and epitaxial regions 330, 332, and 334) and not filled in by a doped epitaxial material. The undercut regions 336 may be filled in by a dielectric material, e.g., dielectric material 312 or another dielectric. In the example of FIG. 3, the undercut region 336b is aligned with the p-n junction 326. In other embodiments, the p-n junction 326 may be to the right or the left of the undercut region 336b, or between multiple undercut regions 336 between the emitter regions 332 and collector regions 334. In some embodiments, a base region 330 (e.g., base region 330b) may be directly adjacent to an emitter region 332 (e.g., to emitter region 332), without an intervening undercut region 336. Likewise, in some embodiments, an emitter region 332 (e.g., emitter region 332b) may be directly adjacent to a collector region 334 (e.g., to collector region 334a). Alternatively, a greater number of undercut regions 336 may be between base regions 330 and emitter regions 332, and/or between emitter regions 332 and collector regions 334. In general, the spacing between the base, emitter, and collector regions can be adjusted to modulate the voltage and current characteristics of device 300, enabling customization for specific applications.

The base regions 330 and emitter regions 332 are coupled to VSS (e.g., ground connection 106), and collector regions 334 are coupled to PAD (e.g., pad 104), as shown in FIG. 1. For example, each of the epitaxial regions 330, 332, and 334 may have a respective conductive contact, and a metallization stack with interconnects coupled to the conductive contacts may be formed over the device 300. An example metallization stack is shown in FIG. 7. The metallization stack may provide interconnects coupling the base regions 330 and emitter regions 332 to VSS, and interconnects coupling the collector regions 334 to an I/O pad. The vertical current path for ESD protection flows through the base, emitter, and collector regions, down to the wells in the subfin region, which includes the p-n junction 326.

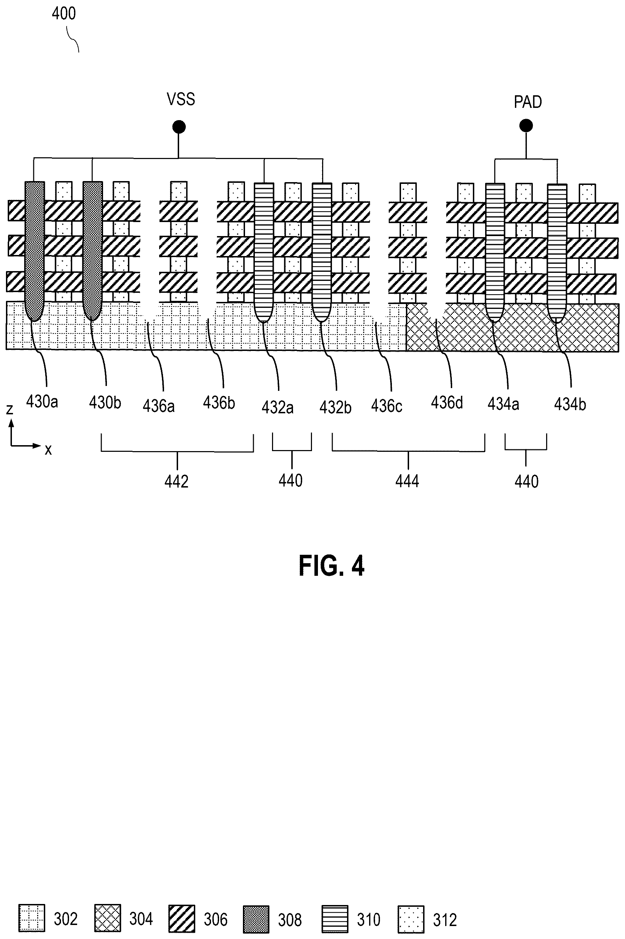

FIGs. 4-6 illustrate several variations on the device 300 of FIG. 3. One or more of the variations illustrated in FIGs. 4-6 may be combined.

FIG. 4 is a cross-section of a second bipolar device 400 formed in a subfin region with greater base-to-emitter and emitter-to-collector spacing, according to some embodiments of the present disclosure. The bipolar device 400 includes base regions 430, emitter regions 432, and collector regions 434, which are similar to the base regions 330, emitter regions 332, and collector regions 334 described with respect to FIG. 3. The second bipolar device 400 includes a subfin including a first subfin material 302 and a second subfin material 304, as described with respect to FIG. 3.

In the device 300 of FIG. 3, a single undercut region 336a was between the base regions 330 and the emitter regions 332, and another single undercut region 336b was between the emitter regions 332 and the collector regions 334. In the bipolar device 400, two undercut regions 436a and 436b are between the base regions 430 and emitter regions 432, and two undercut regions 436c and 436d are between the emitter regions 432 and collector regions 434. Changing the number of undercut regions between the B, C, and E regions alters the distance between the respective regions. For example, in FIG. 4, a first distance 440 between adjacent ones of the emitter regions 432 or adjacent ones of the base regions 430 is less than a second distance 442 between the base regions 430 and the emitter regions 432. Likewise, the first distance 440 between adjacent epitaxial regions within the B, C, and E is less than another distance 444 between the emitter regions 432 and the collector regions 434. Selecting a particular number of undercut regions 436 to adjust relative distances between the base and emitter, and/or between the base and collector, can modulate voltage and current characteristics of the bipolar device, e.g., to meet specific needs the IC.

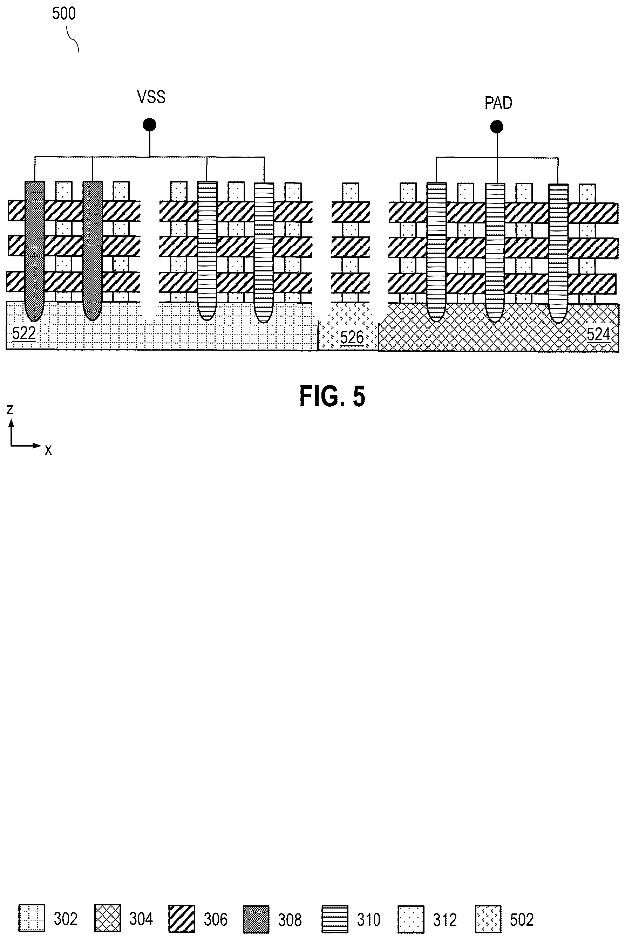

FIG. 5 is a cross-section of a third bipolar device 500 formed in a subfin region with a portion of the subfin having natural doping levels, according to some embodiments of the present disclosure. The bipolar device 500 includes base regions, emitter regions, and collector regions, which are similar to the base regions 330, emitter regions 332, and collector regions 334 described with respect to FIG. 3. The bipolar device 500 includes a subfin including a first subfin material 302 in a first well 522 and a second subfin material 304 in a second well 524. The subfin in FIG. 5 further includes a third subfin material 502 in a subfin region 526, which is between the first well 522 and the 524. The third subfin region 526 is arranged at least partly under one or more undercut regions between the emitter and collector regions.

As noted above, the first subfin material 302 and second subfin material 304 may be oppositely-doped semiconductor materials. The third subfin material 502 may be an undoped or naturally doped semiconductor material, i.e., the same base material as the first subfin material 302 and the second subfin material 304, but without any additional dopants. For example, the subfin region 526 may include undoped silicon, while first well 522 includes n-doped silicon, and second well 524 includes p-doped silicon. Including an undoped or lower-doped region between the n-well and the p-well can vary the junction breakdown voltage and current of the bipolar device 500.

In another example, one of the p-well or the n-well may include one or more regions with a lower dopant concentration, e.g., a native doping concentration. For example, a region of the first well 322 (in FIG. 3) or a region of the first well 522 (in FIG. 5) may have a native region, e.g., between the base regions and the emitter regions (e.g., under the undercut region 336a in FIG. 3). This region may include dopants of a same dopant type as first subfin material 302, but at a different (lower) concentration.

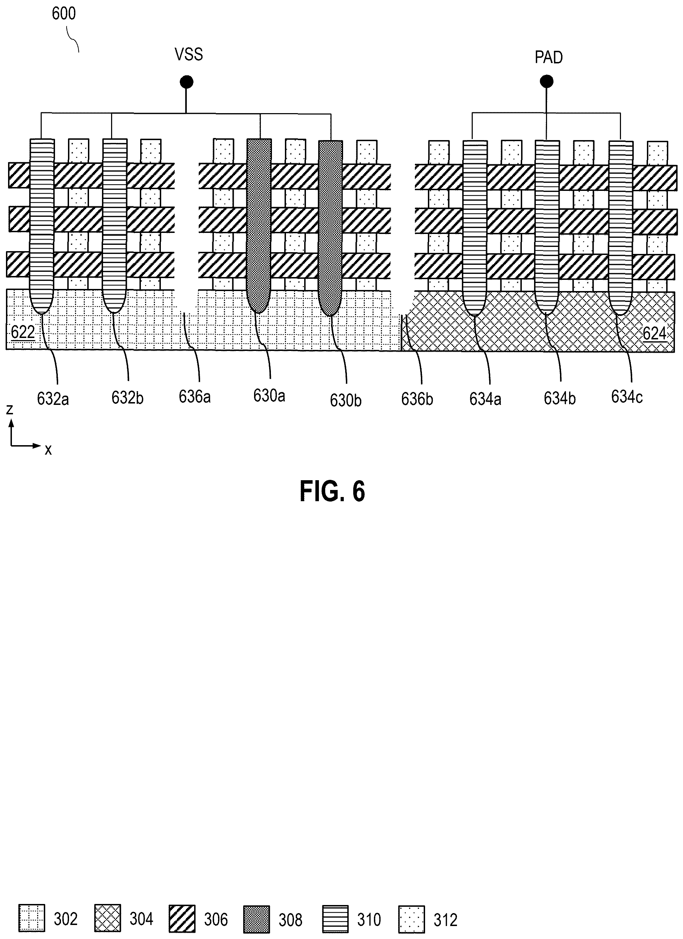

FIG. 6 is a cross-section of a fourth bipolar device 600 formed in a subfin region with the base and emitter swapped, according to some embodiments of the present disclosure. The bipolar device 600 includes a subfin including a first well 622 including a first subfin material 302 and a second well 624 including a second subfin material 304, as described with respect to FIG. 3. The bipolar device 600 includes base regions 630 and emitter regions 632 over the first well 622, and collector regions 634 over the second well 624. The base regions 630, emitter regions 632, and collector regions 634 are similar to the base regions 330, emitter regions 332, and collector regions 334 described with respect to FIG. 3. However, in the bipolar device 600, the position of the base regions 630 and emitter regions 632 have been swapped relative to FIG. 3. In particular, in the bipolar device 600, the base regions 630, which includes a different dopant type from the emitter regions 632 and collector regions 634, are situated between the emitter regions 632 and collector regions 634. Swapping the base regions 630 and emitter regions 632, as shown in FIG. 6, can increase the V_{hold} 214 compared to the arrangement of FIG. 3.

### Example Cross-Section with Bipolar Device and Transistors

FIG. 7 is a cross-section of an IC 700 including a bipolar device region with a retained subfin and a transistor region with the subfin removed, according to some embodiments of the present disclosure. The IC 700 includes transistor region 710 including transistor 712a, 712b, and 712c. The transistor region 710 may alternately be referred to as a logic region or compute region of the IC 700. The IC 700 further includes a bipolar device region 720, which includes one or more bipolar devices 722. The bipolar device 722 is similar to the bipolar device 300. In other embodiments, the bipolar device 722 may include any of the variations shown in FIGs. 4-6 or described above. The IC 700 may include any number of transistors 712 and bipolar devices 722, e.g., many more than shown in FIG. 7.

The IC 700 includes a device layer 750, in which the transistors and bipolar device 722 are formed. The bipolar device region 720 includes a retained subfin 724, and the p-n junction of the bipolar device 722 is formed in the retained subfin 724, as described above. The transistor region 710 does not include a subfin; in the transistor region 710, the subfin has been removed, allowing contacts 706 to be formed below the transistors 712. The transistors 712 each include two epitaxial S/D regions, formed from the first doped material 308 and second doped material 310 described with respect to FIG. 3. The S/D regions of the transistors 712 may be formed during the same processes for forming the base regions 330, emitter regions 332, and collector regions 334 of the bipolar device 722. The transistors 712 further include a gate electrode 702, replacing the dielectric material 312 forming dummy gates.

In the example of FIG. 7, the transistors 712 include both frontside contacts and backside contacts. Frontside contacts are formed over the transistors 712 and couple the transistors 712 (specifically, the gate electrodes 702 of the transistors 712) to interconnects 704 within a frontside metallization stack 752. The bipolar device 722 is also coupled to interconnects 704 within the frontside metallization stack 752, e.g., via frontside contacts formed over each of the base regions 330, emitter regions 332, and collector regions 334. Backside transistor contacts are formed under the transistors 712 and couple the transistors 712 (specifically, the S/D regions of the transistors 712) to interconnects 704 within a backside metallization stack 754. In various embodiments, different ones of the source, gate, and drain regions of the transistors 712 may be coupled to the frontside metallization stack 752 or the backside metallization stack 754. In some embodiments, both S/D regions and the gate are coupled to the backside metallization stack 754. While each metallization stack 752 and 754 is illustrated as having two layers, it should be understood that the metallization stacks 752 and 754 may have additional layers, and may include the same materials (as shown) or different materials, either within a given metallization stack or between the two metallization stacks.

### Example devices

The circuit devices with bipolar devices disclosed herein may be included in any suitable electronic device. FIGS. 8-11 illustrate various examples of apparatuses that may include the one or more bipolar devices as disclosed herein, which may have been fabricated using the processes disclosed herein.

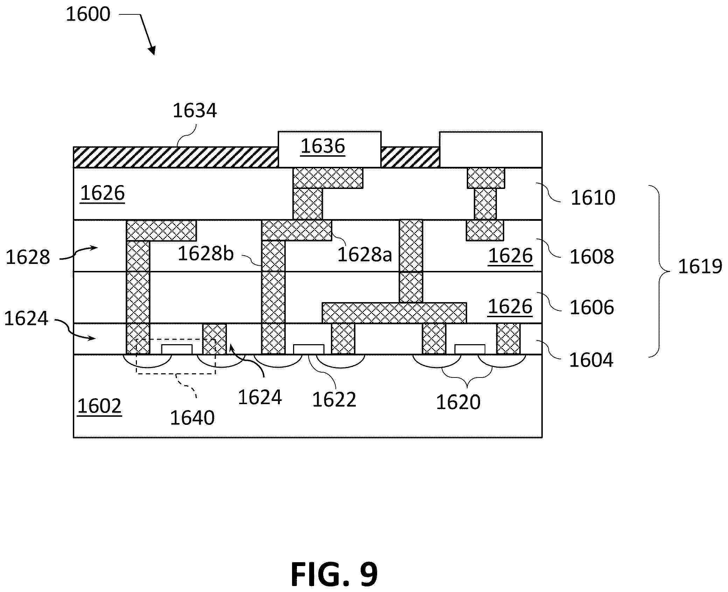

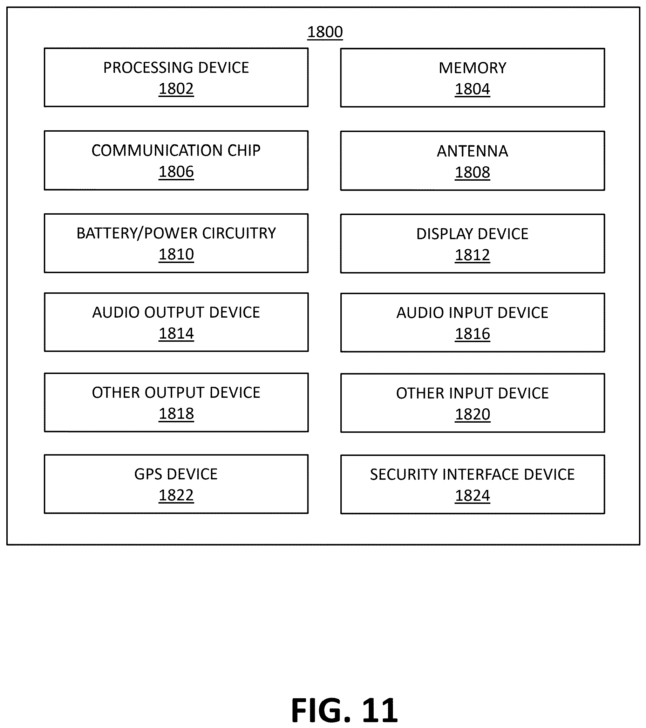

FIG. 8A and 8B are top views of a wafer and dies that include one or more IC structures including one or more bipolar devices in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 1-7, or any further embodiments of the IC structures described herein). After the fabrication of the semiconductor product is complete (e.g., after manufacture of one or more IC structures with one or more of the transistors as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more of the transistors as disclosed herein may take the form of the wafer 1500 (e.g., not singulated) or the form of the die 1502 (e.g., singulated). The die 1502 may include one or more transistors (e.g., one or more of the transistors 1640 of FIG. 9, discussed below) and/or supporting circuitry to route electrical signals to the transistors, as well as any other IC components (e.g., one or more of the non-planar transistors described herein). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 11) or other logic that is configured to store information in the memory devices or execute instructions stored in the memory array.

FIG. 9 is a cross-sectional side view of an IC device 1600 that may include one or more bipolar devices in accordance with any of the embodiments disclosed herein. The IC device 1600 may be formed on a substrate 1602 (e.g., the wafer 1500 of FIG. 8A) and may be included in a die (e.g., the die 1502 of FIG. 8B). The substrate 1602 may be any substrate as described herein. The substrate 1602 may be part of a singulated die (e.g., the dies 1502 of FIG. 8B) or a wafer (e.g., the wafer 1500 of FIG. 8A).

The IC device 1600 may include one or more device layers 1604 disposed on the substrate 1602. The device layer 1604 may include features of one or more transistors 1640 (e.g., metal-oxide-semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 9 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross-section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1600 may include one or more bipolar devices at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 9 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 9). Although a particular number of interconnect layers 1606-1610 is depicted in FIG. 9, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 9. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 9. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

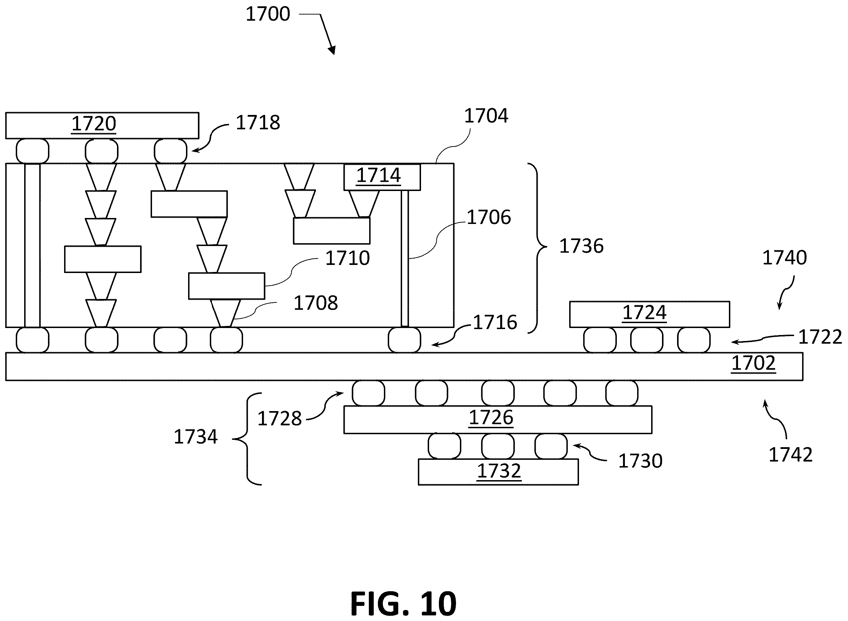

FIG. 10 is a cross-sectional side view of an IC device assembly 1700 that may include components having or being associated with (e.g., being electrically connected by means of) one or more bipolar devices in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include one or more of the non-planar transistors disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 10 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 10), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 10, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 8B), an IC device (e.g., the IC device 1600 of FIG. 9), or any other suitable component. In some embodiments, the IC package 1720 may include one or more bipolar devices, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 10, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 10 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 11 is a block diagram of an example computing device 1800 that may include one or more bipolar devices in accordance with any of the embodiments disclosed herein. For example, any suitable ones of the components of the computing device 1800 may include a die (e.g., the die 1502 (FIG. 8B)) having one or more bipolar devices. Any one or more of the components of the computing device 1800 may include, or be included in, an IC device 1600 (FIG. 9). Any one or more of the components of the computing device 1800 may include, or be included in, an IC device assembly 1700 (FIG. 10).

A number of components are illustrated in FIG. 11 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 11, but the computing device 1800 may include interface circuitry for coupling to the one or more components. For example, the computing device 1800 may not include a display device 1812, but may include display device interface circuitry (e.g., a connector and driver circuitry) to which a display device 1812 may be coupled. In another set of examples, the computing device 1800 may not include an audio input device 1816 or an audio output device 1814, but may include audio input or output device interface circuitry (e.g., connectors and supporting circuitry) to which an audio input device 1816 or audio output device 1814 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random access memory (STT-MRAM).

In some embodiments, the computing device 1800 may include a communication chip 1806 (e.g., one or more communication chips). For example, the communication chip 1806 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1806 may implement any of a number of wireless standards or protocols, including but not limited to Institute for Electrical and Electronic Engineers (IEEE) standards including Wi-Fi (IEEE 1402.11 family), IEEE 1402.18 standards (e.g., IEEE 1402.18-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.18 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.18 standards. The communication chip 1806 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1806 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1806 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1806 may operate in accordance with other wireless protocols in other embodiments. The computing device 1800 may include an antenna 1808 to facilitate wireless communications and/or to receive other wireless communications (such as AM or FM radio transmissions).

In some embodiments, the communication chip 1806 may manage wired communications, such as electrical, optical, or any other suitable communication protocols (e.g., the Ethernet). As noted above, the communication chip 1806 may include multiple communication chips. For instance, a first communication chip 1806 may be dedicated to shorter-range wireless communications such as Wi-Fi or Bluetooth, and a second communication chip 1806 may be dedicated to longer-range wireless communications such as GPS, EDGE, GPRS, CDMA, WiMAX, LTE, EV-DO, or others. In some embodiments, a first communication chip 1806 may be dedicated to wireless communications, and a second communication chip 1806 may be dedicated to wired communications.

The computing device 1800 may include a battery/power circuitry 1810. The battery/power circuitry 1810 may include one or more energy storage devices (e.g., batteries or capacitors) and/or circuitry for coupling components of the computing device 1800 to an energy source separate from the computing device 1800 (e.g., AC line power).

The computing device 1800 may include a display device 1812 (or corresponding interface circuitry, as discussed above). The display device 1812 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1814 (or corresponding interface circuitry, as discussed above). The audio output device 1814 may include any device that generates an audible indicator, such as speakers, headsets, or earbuds, for example.

The computing device 1800 may include an audio input device 1816 (or corresponding interface circuitry, as discussed above). The audio input device 1816 may include any device that generates a signal representative of a sound, such as microphones, microphone arrays, or digital instruments (e.g., instruments having a musical instrument digital interface (MIDI) output).

The computing device 1800 may include another output device 1818 (or corresponding interface circuitry, as discussed above). Examples of the other output device 1818 may include an audio codec, a video codec, a printer, a wired or wireless transmitter for providing information to other devices, or an additional storage device.

The computing device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may include a global positioning system (GPS) device 1822 (or corresponding interface circuitry, as discussed above). The GPS device 1822 may be in communication with a satellite-based system and may receive a location of the computing device 1800, as known in the art.

The computing device 1800 may include a security interface device 1824. The security interface device 1824 may include any device that provides security features for the computing device 1800 or for any individual components therein (e.g., for the processing device 1802 or for the memory 1804). Examples of security features may include authorization, access to digital certificates, access to items in keychains, etc. Examples of the security interface device 1824 may include a software firewall, a hardware firewall, an antivirus, a content filtering device, or an intrusion detection device.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides an integrated circuit (IC) including a subfin layer including a first subfin region; and a second subfin region, where the first subfin region and the second subfin region have different dopants; a first plurality of epitaxial regions over and coupled to the first subfin region; a second plurality of epitaxial regions over and coupled to the first subfin region, the first plurality of epitaxial regions and the second plurality of epitaxial regions having different dopant types; and a third plurality of epitaxial regions over and coupled to the second subfin region.

Example 2 provides the IC of example 1, further including at least one nanoribbon, where the first plurality of epitaxial regions, the second plurality of epitaxial regions, and the third plurality of epitaxial regions extend through breaks in the nanoribbon.

Example 3 provides the IC of example 2, further including a first undercut region between the first plurality of epitaxial regions and the second plurality of epitaxial regions, the first undercut region extending through the at least one nanoribbon and extending partially into the first subfin region.

Example 4 provides the IC of example 3, where the first undercut region is filled with a dielectric material.

Example 5 provides the IC of example 3 or 4, further including a second undercut region between the second plurality of epitaxial regions and the third plurality of epitaxial regions.

Example 6 provides the IC of any preceding example, where a first distance between one of the first plurality of epitaxial regions and an adjacent one of the first plurality of epitaxial regions is less than a second distance between the first plurality of epitaxial regions and the second plurality of epitaxial regions.

Example 7 provides the IC of any of examples 1-5, where a first distance between one of the second plurality of epitaxial regions and an adjacent one of the second plurality of epitaxial regions is less than a second distance between the second plurality of epitaxial regions and the third plurality of epitaxial regions.

Example 8 provides the IC of any preceding example, where the first plurality of epitaxial regions includes at least three epitaxial regions.

Example 9 provides the IC of any preceding example, where the third plurality of epitaxial regions includes at least three epitaxial regions.

Example 10 provides the IC of any preceding example, where the second plurality of epitaxial regions has a same doping type as the third plurality of epitaxial regions, and the second plurality of epitaxial regions is between the first plurality of epitaxial regions and the third plurality of epitaxial regions.

Example 11 provides the IC of any of examples 1-9, where the first plurality of epitaxial regions has a same doping type as the third plurality of epitaxial regions, and the second plurality of epitaxial regions is between the first plurality of epitaxial regions and the third plurality of epitaxial regions.

Example 12 provides the IC of any preceding example, where the subfin layer further includes a third subfin region between the first subfin region and the second subfin region, the third subfin region having a lower dopant concentration than at least one of the first subfin region and the second subfin region.

Example 13 provides the IC of any preceding example, further including a metallization stack over the first, second, and third pluralities of epitaxial regions, where the first plurality of epitaxial regions and the second plurality of epitaxial regions are coupled in the metallization stack.

Example 14 provides an integrated circuit (IC) including a device layer including a transistor region including a gate-all-around (GAA) transistor; and a bipolar device region including epitaxial regions of a bipolar device; and a subfin layer below the bipolar device region, the subfin layer including a first subfin region coupled to a first portion of the epitaxial regions; and a second subfin region coupled to a second portion of the epitaxial regions, where the first subfin region and the second subfin region are a p-n junction of the bipolar device.

Example 15 provides the IC of example 14, where the subfin layer does not extend under the transistor region of the device layer.

Example 16 provides the IC device of example 14 or 15, further including a metallization stack, the device layer between the subfin layer and the metallization stack, where the epitaxial regions of the bipolar device are coupled to interconnects in the metallization stack.

Example 17 provides the IC device of example 16, further including a second metallization stack, where the device layer is between the metallization stack and the second metallization stack.

Example 18 provides the IC device of example 17, where the second subfin layer is between the bipolar device region of the device layer and the second metallization stack.

Example 19 provides an integrated circuit (IC) including a first subfin region; a second subfin region adjacent to the first subfin region, where the first subfin region and the second subfin region include different dopants; a first epitaxial region over the first subfin region; a second epitaxial region over the first subfin region, the first epitaxial region and the second epitaxial region having different dopants; and a third epitaxial region over the second subfin region.

Example 20 provides the IC of example 19, further including a first contact coupled to the first epitaxial region and a second contact coupled to the second epitaxial region, the first contact coupled to the second contact.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit, IC, comprising:
a subfin layer comprising:
a first subfin region; and
a second subfin region, wherein the first subfin region and the second subfin region have different dopants;
a first plurality of epitaxial regions over and coupled to the first subfin region;
a second plurality of epitaxial regions over and coupled to the first subfin region, the first plurality of epitaxial regions and the second plurality of epitaxial regions having different dopant types; and
a third plurality of epitaxial regions over and coupled to the second subfin region.

2. The IC of claim 1, further comprising at least one nanoribbon, wherein the first plurality of epitaxial regions, the second plurality of epitaxial regions, and the third plurality of epitaxial regions extend through breaks in the nanoribbon.

3. The IC of claim 2, further comprising a first undercut region between the first plurality of epitaxial regions and the second plurality of epitaxial regions, the first undercut region extending through the at least one nanoribbon and extending partially into the first subfin region.

4. The IC of claim 3, wherein the first undercut region is filled with a dielectric material.

5. The IC of claim 3 or 4, further comprising a second undercut region between the second plurality of epitaxial regions and the third plurality of epitaxial regions.

6. The IC of any of claims 1-5, wherein a first distance between one of the first plurality of epitaxial regions and an adjacent one of the first plurality of epitaxial regions is less than a second distance between the first plurality of epitaxial regions and the second plurality of epitaxial regions.

7. The IC of any of claims 1-5, wherein a first distance between one of the second plurality of epitaxial regions and an adjacent one of the second plurality of epitaxial regions is less than a second distance between the second plurality of epitaxial regions and the third plurality of epitaxial regions.

8. The IC of any of claims 1-7, wherein the first plurality of epitaxial regions comprises at least three epitaxial regions.

9. The IC of any of claims 1-8, wherein the third plurality of epitaxial regions comprises at least three epitaxial regions.

10. The IC of any of claims 1-9, wherein the second plurality of epitaxial regions has a same doping type as the third plurality of epitaxial regions, and the second plurality of epitaxial regions is between the first plurality of epitaxial regions and the third plurality of epitaxial regions.

11. The IC of any of claims 1-9, wherein the first plurality of epitaxial regions has a same doping type as the third plurality of epitaxial regions, and the second plurality of epitaxial regions is between the first plurality of epitaxial regions and the third plurality of epitaxial regions.

12. The IC of any of claims 1-11, wherein the subfin layer further comprises a third subfin region between the first subfin region and the second subfin region, the third subfin region having a lower dopant concentration than at least one of the first subfin region and the second subfin region.

13. The IC of any of claims 1-12, further comprising a metallization stack over the first, second, and third pluralities of epitaxial regions, wherein the first plurality of epitaxial regions and the second plurality of epitaxial regions are coupled in the metallization stack.

14. The IC of any of claims 1-13, further comprising:
a device layer comprising:
a transistor region comprising a gate-all-around (GAA) transistor; and
a bipolar device region comprising the first plurality of epitaxial regions, the second plurality of the epitaxial regions, and the third plurality of epitaxial regions..

15. The IC of claim 14, wherein the subfin layer does not extend under the transistor region of the device layer.
